## Europäisches Patentamt
## European Patent Office
## Office européen des brevets

(11) Publication number: **0 140 971**
**B1**

# EUROPEAN PATENT SPECIFICATION

(45) Date of publication of patent specification: **09.08.89**

(21) Application number: **82903262.2**

(22) Date of filing: **09.11.82**

(86) International application number:
**PCT/JP82/00433**

(87) International publication number:
**WO 84/01967 24.05.84 Gazette 84/13**

(51) Int. Cl.⁴: **G 03 C 5/00,** G 03 C 5/24,
C 23 C 26/00

(54) **PERMANENT COLOR PHOTOGRAPHIC PICTURE.**

(43) Date of publication of application:
**15.05.85 Bulletin 85/20**

(45) Publication of the grant of the patent:
**09.08.89 Bulletin 89/32**

(84) Designated Contracting States:
**DE FR GB**

(56) References cited:
**DE-A-1 186 744**
**DE-A-2 004 214**
**FR-A-1 426 556**

**CHEMICAL ABSTRACTS, 1956, column 16498c,
Columbus, Ohio, US; & SU - A - 103 308 (D.L.
MUKHA) 25-07-1956**

(73) Proprietor: **KABUSHIKIKAISHA ARIGA
SHASHINKAN**
**3-6, Ginza 7-chome Chuo-ku
Tokyo 104 (JP)**

(72) Inventor: **TOMITA, Seiji**
**23-2 Minamimaioka 4-chome Totsuka-ku
Yokohama-shi Kanagawa 244 (JP)**
Inventor: **ARIGA, Nagatoshi**
**14-19, Seijo 6-chome Setagaya-ku
Tokyo 157 (JP)**

(74) Representative: **Moore, Anthony John et al
Gee & Co. Chancery House Chancery Lane
London WC2A 1QU (GB)**

The file contains technical information
submitted after the application was filed and
not included in this specification

Courier Press, Leamington Spa, England.

**Description**

This invention relates to a permanent colour photograph. More particularly this invention relates to a colour photograph which contains no organic materials and can be conserved permanently, and also relates to a method of manufacturing the same.

Recently, photography has made great progress together with an increase of a demand for photographs, especially colour photographs. However, as a photographic image is formed using organic materials, and as colour images are reproduced using organic dyes, the conservation of the photographic image is limited in spite of the improvements on its heat and moisture-resisting properties or light resistance, or despite the development of a method to protect its surface with a resin layer such as an acrylic resin layer.

In order to solve this problem, it has been known to print an image in intaglio or with screen on a ceramic plate using inorganic pigments and fire the plate to produce a permanently preservable reproduction. According to this method, however, it was impossible to obtain the same resolution and tone reproduction as those in photographic reproduction. Especially this problem was serious in comparatively small images. These known printing techniques had a restricted application since they needed printing apparatuses and special techniques. Moreover, firing temperatures for colour reproduction had to be adjusted individually depending on each pigment, and the firing process had to be repeatedly carried out beginning with a pigment which needed the highest firing temperature. The whole procedure was, therefore, complicated and colours to be reproduced were limited.

It has been also known to form an image by hardening a non-image part of a light hardening element and developing the unhardened and tacky image part with a toner, or to form a colour image by providing further the light hardening element over the obtained image and repeating the same procedure as above (e.g., U.S. Patent No. 3,649,268). In this case, it is possible to develop an image using inorganic pigments so that the colour of the image obtained would not change or fade. However, since substances which support the pigments are organic matter, the obtained image cannot be permanently preserved as it is.

Another known method is to imagewise expose photosensitive resin provided on a ceramic plate, develop the image with a slurry containing inorganic pigments and fire it to produce a monochromatic permanent photograph. When many layers of an image are formed and fired according to this method, solvent molecules constituting a slurry remain in the photosensitive resin and evaporate during the firing process to destroy the image. It is, therefore, impossible to form a colour image by a single firing process. Besides, no combination of pigments that can give a good colour reproduction by a single firing process has been known so far.

DE—B—1,186,744 discloses a method of photographic reproduction in which a light-sensitive polymer is exposed to a light image and subjected to uniform softening conditions, whereby less exposed areas become softer and more adhesive than more exposed ares. Fine particles of a pigment are then applied to the layer, and the particles which have not adhered removed. Although the use of a combination of non-organic pigments for colour reproduction is disclosed, there is no disclosure of a combination of pigments that can give the quality natural colour reproduction of the present invention.

The present inventors made various studies to solve the above-mentioned problems and discovered that, when particles of inorganic pigments are allowed to adhere to a photosensitive element which has been imagewise exposed beforehand (dry development) and the developed image is fired under certain conditions, the photosensitive element disappears very easily and a natural coloured permanent photographic image of good quality can be obtained. The inventors also discovered a combination of pigments having almost the same melting points and which are able to reproduce excellent flesh colour.

Accordingly, the primary object of this invention is to provide a natural coloured permanent photograph which is not subject to colour fading and/or change and has an excellent resolution, tone and colour reproduction to give an image of good quality.

Another object of the present invention is to provide an easy process for producing a natural coloured permanent photograph which causes no colour fading and/or change and has an excellent resolution, tone and colour reproduction.

The third object of this invention is to provide a firing process which is suitable for producing a natural coloured permanent photograph with an image of good quality using a photosensitive element.

The present invention provides a permanent photograph having a natural colour image formed of inorganic pigments on a base plate consisting of an inorganic material such as ceramic material, silver or copper, and method for providing it. The method comprises the following two processes:

(A) A process for forming a colour image by repeating at least the procedures (a)—(c):

    (a) providing a photosensitive layer on a base plate consisting, at least, of an inorganic material such as ceramic material, silver or copper,

    (b) imagewise exposing the photosensitive layer through a direct screened, colour separated lithographic film, and

    (c) developing the image with a toner containing special inorganic pigments, and removing the excess toner, and

(B) A process for dissolving the photosensitive element and at the same time fusing the inorganic pigments to the base plate by firing at higher than 400°C, at least, after the final development in the above characterised in that said inorganic pigments are a mixture of KAIHEKI and TANSUISHOKU for cyan colouring, OHSHOKU for yellow colouring, and a mixture of MARON and SHOENSHI for magenta colouring and TSUYAGURO for black colouring.

The base plate used in this invention must be able to stand heating at a temperature higher than 400°C. It may be formed, for example, of a non-metallic inorganic material such as china, porcelain, other ceramic material or glass having a high melting point. Alternatively the base plate may comprise silver and/or copper. Plates of non-metallic inorganic material, and/or silver are chosen since inorganic pigments that are to form an image can directly fuse to them. From the economical viewpoint, plates of inorganic materials are more preferable.

A base plate can be coated with a photosensitive layer using a brush or a roller, or it can be soaked in a photosensitive solution and dried by hanging. Other usual methods to provide a photosensitive layer on a printing plate, such as spraying the plate with a photosensitive solution or sprinkling the solution over the plate with a wheeler, can also be used.

As a photosensitive layer, in this invention, any photosensitive compounds which rapidly change their chemical and/or physical properties when they are exposed to light are usable, e.g., a high molecular compound having reactive groups which undergoes polymerization or crosslinking reaction when exposed, a mixed compound of a nonreactive polymer and a monomer which can carry out a photopolymerization reaction, or a high molecular compound containing polymer and an agent that crosslinks said polymers. Examples of such photosensitive compounds are gelatin or albumin mixed with diazonium salt or dichromate, photosensitive resins such as cinnamic acid ester of polyvinylalcohol which has a photosensitive cinnamoyl group, the so-called photosensitive rubber solution having a photosensitive azide group, photosensitive nylon having a photosensitive acryloyl group, unsaturated polyester containing a crosslinking agent such as acrylamide, nonreactive macromolecules such as cellulose ethylate mixed with acrylic acid derivatives which carry out a photopolymerization reaction, or quinone diazides which become soluble in an alkaline solution when exposed to light.

If metals are contained in such a photosensitive layer, they might obstruct colour reproduction of an image after its firing. Therefore, layers containing no metal are preferable — for example, photosensitive compounds mainly consisting of photo-hardening resins such as polyvinyl cinnamate group (e.g., KPR marketed by Eastman Kodak Company, TPR by Tokyo Ohka Kogyo Co., Ltd., SPR by Sampo Chemical Research Lab.), polyvinyl cinnamilidene acetate group (e.g., KOR marketed by Eastman Kodak Company), polyvinyl p-azidobenzoate group (e.g., FPER marketed by Fuji Yakuhin Kogyo Co., Ltd.).

It is possible to add, if necessary a well-known sensitizer to the above-mentioned photosensitive compounds in order to improve their sensitivity, and to provide an adhesive layer between the base plate and the photosensitive layer so that development is carried out effectively.

In this invention, when photo-hardening compounds are used as a photosensitive element, imagewise exposure is carried out using a positive film, while in the case of using photo-decomposing compounds, a negative film is used. In order to obtain a colour image, it is necessary to use a direct screened and colour separated negative or positive film. As to their exposure, although any kinds of light sources that are generally applied for an exposure of photosensitive resin can be used, e.g., a high pressure mercury lamp or an ultra high pressure mercury lamp, the so-called metal halide lamp is particularly desirable. In addition to an ordinary imagewise exposure with these lamps, a certain amount of full exposure improves the tone reproduction of a shadow part.

The present invention's development process after the exposure can be carried out using a toner containing inorganic pigments without any prior treatment when tackiness of the surface of a photosensitive layer is varied by its exposure. However, even when the layer does not show any change of tackiness on its surface after its exposure, or when the tackiness is varied, it is desirable to develop images with a toner after maintaining the exposed plate in an atmosphere of solvent vapor or after spraying the exposed photosensitive layer with a solvent to make the image part swell so that the said part's toner acceptability can be adjusted.

These processes may be effective to secure uniform development and to obtain an image of good quality with an excellent resolution and tone reproduction. Therefore when a photo-hardening layer is used, it is preferable to maintain the plate in an atmosphere of a solvent or spray the layer with a solvent that can make the non-hardened element of an image part swell or dissolve. While, if a photosensitive layer in which the solubility varies due to photolysis caused by its exposure is used, it is preferable to use a solvent that can make the exposed part of the layer swell or dissolve. However, in the latter case, it is possible to develop an unexposed part by using a solvent that can make the said part swell but cannot swell an exposed part. Thus, when quinone diazide, of which solubility varies as a result of its photolytic reaction, is used, both negative and positive films can be used by choosing a solvent in the swelling treatment before development. Also, not only a positive image but a negative one can be easily obtained. To be more concrete, when quinone diazide is exposed using a negative film, a positive image can be obtained by making the image part swell with steam after exposure and developing the exposed part with a toner, while a negative image can be obtained by making the non image part swell with vapor of an organic solvent after exposure and developing the said part with a toner.

In this invention an adjustment of the photosensitive layers' toner acceptability is carried out at a temperature of 5°C—60°C, preferably at 10°C-40°C, though the exact temperature depends on the kind of photosensitive layer and solvent used.

A solvent (utilized to adjust the above-mentioned toner acceptability before development) can be suitably chosen from those that can make an unexposed part of the photosensitive layer swell if the layer used is of the photohardening type. On the other hand, if the layer used is the photodecomposing type, a solvent that can make either an exposed part or an unexposed part swell can be selected. When, for instance, photosensitive resin belonging to polyvinyl alcohol group having a cinnamoyl group is used as a photosensitive layer, such a solvent as xylene, toluene, ethyl acetate or n-butyl acetate can be used to make the element swell for the purpose of adjusting its toner acceptability before development. In particular, n-butyl acetate is preferred in the present invention. Also, it is possible to use a mixture of two or more of these solvents, or to prepare a mixture with other solvents that can adjust the swelling effect. Thereby, a subtle control of the said toner acceptability becomes feasible.

In the present invention the desirable thickness of a photosensitive layer to be applied on a base plate is 0.5—15μm, preferably 1—10μm. If the photosensitive layer is too thin, sufficient image density cannot be obtained. While, if the layer is too thick, it tends to become uneven and to cause an image lacking in uniformity. A thick photosensitive layer also results in an undesired prolonged time for drying, for adjusting its toner acceptability before development, or for firing it to dissolve the layer and let inorganic pigments of the image part fuse onto the base plate.

The development of this invention can be carried out by sprinkling or spraying a slurry containing pigments over a photosensitive layer after its exposure, or by wiping the image, which has been made swollen with a solvent or its vapor, with a piece of cloth or fur having thereon a powdered toner. In the former case, it is necessary to disperse pigments in a dispersing agent (e.g., an alcoholic dispersant such as methanol, isopropyl alcohol or n-butyl alcohol) which is able to adjust the image density. Then, the process for adjusting the toner acceptability of an image part can be omitted. However, the use of a slurry makes the development procedure complicated and tends to cause an uneven image. Moreover, when a "many-layered" image is to be fired, evaporation of solvent contained in a slurry may destroy the image.

On the other hand, development using a powdered toner gives better results. Dry development is a method in which a dry piece of cloth or fur is used either in an atmosphere of solvent vapor for making the image part swell or in an atmosphere substantially without the presence of the vapor, or a method in which to develop the image, the exposed photosensitive layer is passed through a developing room where the toner is flowed in an agitated state. Therefore, uniform development with an excellent resolution is attainable with dry development, if the development is carried out under a suitable pressure or if the agitation is controlled. The results are especially satisfactory when these developments are carried out in an atmosphere of a solvent vapor which can swell image parts. Consequently, the concept of dry development in the present invention includes development using a toner adsorbing the solvent vapor in an atmosphere of said vapor which makes an image part swell.

Since an organic material is exhausted by firing at higher than 500°C, inorganic pigments which are able to fuse at 500°C are preferable in the present invention.

To give fine magenta colouring after heating at a temperature higher than 500°C, the corresponding overglaze colour used in the ceramic art is particularly suitable. Therefore, it is preferable to use the overglaze colours for cyanic, yellow and black colouring that are necessary for a colour image reproduction, as they contain pigments which have nearly the same melting points to that of said overglaze colour for magenta. This is important in the firing process, especially when producing a permanent colour photograph by a single firing process which will be described later.

It is well-known that overglaze colours are comprised of leadglass frit as a flux and pigments of inorganic metal oxides as a colouring substance. In this invention frits that contain no feldspar, especially those of $K_2O$, $PbO$—$SiO_2$ system and $Na_2O$, $PbO$—$SiO_2$ system are preferred. As to pigments, the following are used: for cyan colouring a mixture of KAIHEKI and TANSUISHOKU which contain cobalt oxide as a substance giving cyan colour, for yellow colouring OHSHOKU which contains antimony oxide as a substance giving yellow colour, SHOENSHI, which contains gold and MARON for magenta colouring SHOENSHI, and for black colouring TSUYAGURO. The mixing ratio of KAIHEKI and TANSUISHOKU (KAIHEKI/TANSUISHOKU) is 3/2—1/6, preferably 1/1—1/5, and that of MARON and SHOENSHI (MARON/SHOENSHI) is 1/15—1/2, preferably 1/10—1/3.

The pigments used in the present invention are as follows:

# EP 0 140 971 B1

## ( 1 ) OHSHOKU

(unit: weight%)

| Pigment \ Component | ( 1 ) | ( 2 ) | ( 3 ) | ( 4 ) |
|---|---|---|---|---|
| SHIRATAMA | 3 9. 0 | 4 0. 0 | 3 0. 0 | 3 6. 3 |
| TOHNOTSUCHI | 4 7. 0 | 4 4. 0 | 5 6. 0 | 4 5. 4 |
| HINOOKA | 1 2. 0 | 1 3. 0 | 1 3. 8 | 7. 3 |
| BENIGARA | 0. 8 | 0. 8 | —— | —— |
| TOHJIROME | 1. 2 | 2. 2 | 0. 2 | 1 1. 0 |

## ( 2 ) SHOENSHI

| Pigment \ Component | ( 1 ) | ( 2 ) | ( 3 ) |
|---|---|---|---|
| SHIRATAMA | 7 1. 0 | 1 6. 0 | 6 2. 5 |
| TOHNOTSUCHI | 1 4. 5 | 3 4. 0 | 1 2. 5 |
| HINOOKA | 1 4. 5 | —— | 1 2. 5 |
| BENIGARA | —— | 1 6. 0 | 1 2. 5 |
| Borax | —— | 3 4. 0 | —— |
| Pure gold | small amount | | —— |

## ( 3 ) TSUYAGURO (nearly equal to Gloss Black)

| | |
|---|---|
| SHIRATAMA | 5 8. 0 |
| TOHNOTSUCHI | 2 0. 0 |
| SHIROMIDORI | 2 2. 0 |

Chemical composition of the above listed component are as follows:

| HINOOKA: | $SiO_2$ | 99.89% | | |
|---|---|---|---|---|
| TOHNOTSUCHI: | PbO | 86.42% | | |
| | $CO_2$ | 11.60% | | |
| | $H_2O$ | 2.00% | | |

| SHIRATAMA: | $SiO_2$ | 49.05%, | CaO | 0.62% |
|---|---|---|---|---|
| | PbO | 36.91%, | $K_2O$ | 11.85% |
| | $Fe_2O_3O$ | 0.50%, | $Na_2 + Al_2O_3$ | 0.65% |

BENIGARA (nearly equal to Indian Red):

| | $SiO_2$ | 7.51%, | $Fe_2O_3$ | 88.57% |
|---|---|---|---|---|
| | $Al_2O_3$ | 1.49%, | $H_2O$ | 2.31% |

TOHJIROME: almost pure antimony oxide

SHIROMIDORI: basic copper carbonate (4) MARON

   Cassius purple Base — maroon base containing 1.555g of gold

      maroon base — purple base containing tin and gold in a ratio: tin/gold = 1/4

      $Ag_2CO_3$ — 1.037g.

   Amount of the solvent and the type of the base — 373.2g of maroon

   Composition of the solvent — maroon solvent

        minium — 6 parts

        flint glass — 2.5 parts

        Boric acid — 8 parts

(5) KAIHEKI

| | |
|---|---|
| gray Cobalt Oxide | 20.0% |
| aluminium hydroxide | 74.8% |
| Zinc Oxide | 5.2% |

Colour base of KAIHEKI can be prepared by heating a mixture of above materials at 1300°C in an oxidizing atmosphere. Some of the flux to obtain excellent colour of KAIHEKI using above colour base is shown below:

Example of the flux used for KAIHEKI

| | |
|---|---|
| minium | 50% |
| boric acid | 38.8% |
| zinc oxide | 2.5% |
| potassium carbonate | 8.7% |

(6) TANSUISHOKU

   TANSUISHOKU is prepared by adding zircon and/or copper carbonate to light KAIHEKI so as to make the colour near to the so-called turquoise blue. The composition for TANSUISHOKU is:

| | | | |
|---|---|---|---|
| base frit | 86.5%, | antimony oxide | 1.0% |
| tin oxide | 7.5%, | copper oxide | 0.6% |
| kaoline | 4.06%, | cobalt oxide | 0.1% |

The composition for the above base frit is:

| | | | |
|---|---|---|---|
| minium | 34.0%, | feldspar | 12.0% |
| quartz | 24.0%, | limestone | 7.0% |
| borax | 18.0%, | kaoline | 5.0% |

Since the particle diameter of the toner used in this invention is 0.2μm—30μm, inorganic pigments or their mixture can be used as they are. This diameter determines the resolution of an image finally obtained, which is possible by 68.9 line pairs/cm.

In the present method, the surface of said particles can be covered with resin or treated with a surface active agent so that they can easily adhere to the swollen image part. Such an adjustment of the adhesive ability of the toner is important not only for improving the gradient of an image but also for improving the working process of the present invention. The surface active agent can be selected from any cationic, anionic or nonionic ones depending on the kind of the pigments and/or photosensitive layer to be used. Nonionic surface active agents, especially polyoxyethylene alkyl ethers, are suitable for the pigments that impart cyan and yellow, and the same surfactant group, especially polyoxyethylene sorbitan laurates, are suitable for those that impart magenta and black. For the pigments that impart cyan, yellow and black, an addition of caproic acid is also quite effective. Furthermore, it is preferable to maintain powdered toner in solvent vaporwhich can swell an image part of a photosensitive layer since the solvent adsorbed on the surface of pigments improves the toner's adhesion to an image part and results in an image of excellent and uniform gradation.

Generally speaking, a mixing of at least cyan, yellow and magenta is necessary for the colour reproduction of an image. An addition of black improves the colour reproduction and many other colours are needed for securing its accuracy.

In the present invention, pigments of each colour are applied on an image part one colour after another. Therefore, the colour reproduction is carried out by repeatedly applying a photosensitive layer, exposing with separate colour separation records, and toner developing in sequence. In this case, if flesh colour is chosen as a standard of colour reproduction in order to reproduce flesh colour more faithfully, it is preferable to form images in an order of cyan, yellow, magenta and black respectively.

Excessive pigments adhered during a developing process can be removed off by washing them with a solution or by wiping them with a piece of dry cloth or fur. The former method gives a good image with a low fog density, but if the firing is not carried out after each image formation washing process using a solution is not suitable, since molecules such as those of water and other solvents (which have penetrated into the photosensitive layer) evaporate due to the heat generated during the second or later drying or exposing processes. This evaporation may cause blisters and the image may be destroyed. Therefore, it is preferable to select the latter method wiping off with a piece of cloth or fur, especially chamois is preferred.

The colour image obtained as above is fired with its base plate at higher than 400°C and a permanent colour photograph is obtained.

When a piece of glass which softens at 400°C is used as a base plate, the firing temperature used is also at this temperature. In this case, although pigments may not melt completely, they are fixed on the plate as its surface is softened by heat. Adhesion between the base plate and the pigments can be strengthened by adjusting their heat expansion coefficient — for example, by adding a suitable additive to the pigments (e.g., fine powder of the base glass) to make their coefficient thermal expansion near to that of the base plate. If a ceramic plate which has an extremely high melting point is used as a base plate, the firing process is to be carried out at at temperature higher than 500°C, preferably at higher than 550°C, to be high enough to melt the pigments and let them firmly fix to the base plate. It is possible to increase the firing temperature to 1300°C when pigments with high melting points, e.g., so-called underglaze colours used in the industrial arts, are chosen. However, in order to reproduce good magenta colour by using overglaze colours, firing is to be carried out at temperatures of 500°C—850°C, preferably at 600°C—750°C. During this firing process organic matters other than the pigments dissolve away completely. It is not good to raise the temperature rapidly, since the pigment will come off to damage the image to be formed. Therefore, the firing process should be carried out particularly carefully until the temperature reaches a degree at which the photosensitive layer dissolves away. Since most of the photosensitive layers dissolve away at 200°C, the desirable rate of temperature increase from the room temperature to 200°C is less than 4°C/min, preferably less than 3°C/minute.

The most reliable method for producing a permanent colour photograph is to provide a photosensitive layer newly over the surface of the firstly prepared permanent photograph and repeat the same procedure as the first one. Thus, colour images at least in cyan, magenta and yellow, and preferably black, are prepared and a permanent photograph is obtained. But this process is complicated as each monochromatic permanent photograph is placed one over another.

In the case where pigments having nearly the same melting points are used, firing processes can be reduced to only one after the final developing treatment to avoid the above complication. One method of achieving this is to harden the non image part of a photosensitive layer sufficiently by exposing the whole layer after its developing treatment, then a new photosensitive layer is applied over the resultant surface for a new colour image. Another method is to use a thermosetting compound as the photosensitive layer. In this case, said layer, after its development, may be heated to certain extent so that the obtained image does not have any adverse effect when a new photosensitive layer is recoated on the first image. These two methods can be practiced in combination as well. Thus, it is possible to simplify the whole procedure by replacing each firing process after the developing treatment with a whole exposing process and/or a heating process.

Another method which avoids the complication of the firing process is to provide an intermediate layer between each photosensitive layer to protect the already formed image from any effect of the application of a new photosensitive layer. When a photosensitive resin which is insoluble in water but soluble in an organic solvent, such as cinnamic acid ester of polyvinyl alcohol, is used as a photosensitive layer, the surface of the element after its development is coated with a film of water soluble polymer such as polyvinyl alcohol or polyvinyl pyrolidone, then the photosensitive element is newly applied over said film. On the other hand, when a photosensitive layer mainly consisting of water soluble photosensitive resin is used, a water insoluble polymer (such as ethyl cellulose) may be provided as an intermediate layer.

Among the above-mentioned methods for avoiding the complication of the multi-firing process, the method which uses the thermosetting photosensitive element is particularly desirable in view of its practicability and excellent image reproduction.

Thermosetting photosensitive layers usable in the present invention are, for example, photosensitive polymers having an ethylenically double bond that can conduct thermopolymerization, a photosensitive layer including monomers having an ethylenically double bond which is able to polymerize by heat, or a photosensitive layer that can conduct thermal crosslinking.

In the case where multicolour images are melted to fix the image on a base plate by a single firing, it is important to pay particular attention to destruction of the image caused by organic matter when it dissolves away. Such a risk may be reduced by dissolving the polymer of the upper layer substantially faster than that of the lower layer either by heating the photosensitive layer in an oxygen rich atmosphere, or by using, in the photosensitive layer which is to be newly applied or in the intermediate layer, a polymer which has a lower degree of polymerization than that of the previous layer.

The following examples are provided to illustrate the present invention, but are not to be construed as limiting the present invention in any way.

## Example 1

A photosensitive element mainly consisting of cinnamic acid ester of polyvinyl alcohol was applied on a ceramic plate with a size of 11cm × 11cm to have a thickness of 5μm on dry base. Then the element was exposed to a metal halide ultra high pressure mercury lamp (1kw) at a distance of 50cm during 75 seconds through a direct screened positive film, then the whole surface was exposed for 2 seconds through a filter having a transmission rate of 10%. The obtained ceramic plate was exposed to saturated vapor (25°C) of n-butyl acetate for 5 minutes to make the image part of the element swell and developed with a soft cloth carrying as pigments a mixture of KAIHEKI and TANSUISHOKU (KAIHEKI/TANSUISHOKU = about 0.80; both are produced by ISEHISA Co., Ltd.) of overglaze colours used in the industrial arts. Excessive pigments were removed with chamois leather. The resultant cyan image formed on the ceramic plate had a good resolution and gradation.

The above ceramic plate was placed in a furnace of an oxidizing atmosphere at room temperature. The temperature was raised to 200°C in a rate 2°C/minute, then further raised to 650°C so that the time taken was 70 minutes. As a result, the photosensitive layer had dissolved away completely and the pigments had fixed firmly into the base plate. The obtained permanent photograph had a tolerable cyan image with a reproduction of resolution and gradation as good as those in ordinary photographs.

The same whole process as above was repeated to prepare a yellow image over the cyan one using OHSHOKU produced by Colour Shop KAJITA & Company and obtained a permanent photograph of an image in cyan and yellow. A magenta and a black images were formed over the cyan and yellow images in the same procedure as above respectively using SHOENSHI and TSUYAGURO both produced by ISEHISA Co., Ltd. The resultant permanent colour photograph had an image with an excellent resolution and gradation. Also, its colour reproduction was quite satisfactory.

## Example 2

A permanent colour photograph was prepared in the same manner as in Example 1 except that a mixture of (a) KAIHEKI and (b) TANSUISHOKU (a/b = 0.79) for cyan, TANOHSHOKU for yellow, a mixture of (c) HANA-MARON and (d) SHOENSHI (c/d = 0.3) for magenta, and TSUYAGURO for black (all pigments were products by Colour Shop KAJITA & Co.) were used.

Colour reproduction of the obtained image was highly satisfactory and its resolution and gradation were as good as those in Example 1.

## Example 3

A permanent colour photograph was prepared in the same manner as in Example 2 except that heating at 110°C for 15 minutes was carried out to harden the photosensitive layer instead of all the firing processes except the last one.

The obtained image was as fine as that in Example 2 and was good enough to be appreciated as a photograph.

## Example 4

A permanent colour photograph was prepared in the same manner as in Example 3 except for the following: heating processes for hardening the photosensitive layer were omitted, but a thin film of polyvinyl pyrrolidne having a thickness of 1μm was coated upon each of the photosensitive layers, then the temperature was raised from room temperature to 200°C at an almost constant rate for 2 hours and 50 minutes, and further fired during 1 hour and 10 minutes to reach 650°C.

The resultant colour image was as fine as that obtained in Example 3.

## Example 5

A permanent colour photograph was prepared in the same manner as in Example 3 except that a photosensitive layer mainly consisting of polyvinyl p-azidobenzoate (FPER manufactured by Fuji Yakuhin Kogyo Co., Ltd.) was used instead of the one mainly consisting of cinnamic acid ester of polyvinyl alcohol. The obtained image was good and quite satisfactory.

The colour photograph obtained in the present invention does not contain any organic matter in its base plate or in its image so that it can be preserved permanently. In particular the colour of the image does not change or fade as it consists of inorganic materials. Also, since lithographic films are used for colour reproduction, the image has a resolution and gradation as good as those in ordinary photographs. The permanent photograph is, therefore, not only a fine object for appreciation but also highly useful as a recording material to be preserved for a long time.

It is also highly satisfactory in respect of colour reproduction. Especially when it is a comparatively small photograph, its excellent resolution and gradation make it worthy of appreciation and give it a new value.

The present invention offers a means which can provide such a valuable permanent photograph as above without using expensive printing equipment. Since this means can produce permanent photograph comparatively easily, the present invention contributes to spread the permanent photograph.

According to the present invention, by giving a single firing treatment to the recorded material in multilayers, the picture will preserve for ever. In this respect the present invention has a great industrial applicability, providing not only visual image information but also a new multi-dimensional medium for permanently recording the information.

**Claims**

1. A permanent colour photograph having a colour image formed of inorganic pigments on a base plate, characterised in that the said inorganic pigments are a mixture of KAIHEKI and TANSUISHOKU for cyan colouring, OHSHOKU for yellow colouring, a mixture of MARON and SHOENSHI for magenta colouring and TSUYAGURO for black colouring.

2. A permanent colour photograph as claimed in Claim 1, wherein the base plate comprises a non-metallic inorganic material.

3. A permanent colour photograph as claimed in Claim 1, wherein the base plate comprises silver and/or copper.

4. A permanent colour photograph as claimed in Claims 2 and 3, wherein the base plate comprises a ceramic material silver or copper.

5. A method for producing a permanent colour photograph, which comprises

(A) forming a colour image by repeating each of the following steps (a) to (c),

(a) providing a photosensitive layer on a base plate,

(b) imagewise exposing said photosensitive layer through a direct screened, colour separated lithographic film, then

(c) developing said layer with a toner containing inorganic pigments and removing the excessive toner, and

(B) firing the base plate bearing the formed image, at least after the final colour image formation, by heating the whole up to a temperature higher than 400°C, characterised in that said inorganic pigments comprise a mixture of KAIHEKI and TANSUISHOKU for cyan colouring, OHSHOKU for yellow colouring a mixture of MARON and SHOENSHI for magenta colouring and TSUYAGURO for black colouring.

6. A method for producing a permanent colour photograph as claimed in Claim 5, wherein said magenta image is formed before said black image.

7. A method for producing a permanent colour photograph as claimed in Claim 5 or 6, wherein said firing process is carried out in an oxidizing atmosphere with a heating rate of less than 4°C/minute from the room temperature to 200°C.

8. A method for producing a permanent colour photograph as claimed in Claim 5, wherein the development is carried out after exposing to solvent vapor to swell the surface of the photosensitive layer already imagewise irradiated by light.

9. A method for producing a permanent colour photograph as claimed in any Claim of 5 to 8, wherein said photosensitive layer is thermosetting and its surface is hardened by heating it at a temperature less than 200°C before a new photosensitive layer is recoated.

10. A method for producing a permanent colour photograph as claimed in Claim 5, wherein between each photosensitive layer is provided an intermediate layer which is not affected by application of the next photosensitive layer.

**Patentansprüche**

1. Eine permanente Farbfotografie, die ein durch anorganische Pigmente auf einer Grundplatte gebildetes Farbbild aufweist, dadurch gekennzeichnet, daß die besagten anorganischen Pigmente ein Gemisch von KAIHEKI und TANSUISHOKU für Zyanfärbung, OHSHOKU für Gelbfärbung, ein Gemisch von MARON und SHOENSHI für Magentafärbung und TSUYAGURO für Schwarzfärbung sind.

2. Eine permanente Farbfotografie nach Anspruch 1, bei der die Grundplatte ein nichtmetallisches anorganisches Material umfaßt.

3. Eine permanente Farbfotografie nach Anspruch 1, bei der die Grundplatte Silber und/oder Kupfer umfaßt.

4. Eine permanente Farbfotografie nach den Ansprüchen 2 und 3, bei der die Grundplatte ein keramisches Material, Silber oder Kupfer umfaßt.

5. Ein Verfahren zur Herstellung einer permanenten Farbfotografie, bei dem

(A) ein Farbbild durch Wiederholen jedes der folgenden Schritte (a) bis (c) gebildet wird, indem in

(a) eine lichtempfindliche Schicht auf einer Grundplatte gebildet wird, in

(b) die besagte lichtempfindliche Schicht dem Bild gemäß durch einen direkt gefilterten, farbgetrennten lithografischen Film hindurch belichtet wird, und dann in

(c) die besagte Schicht mit einem anorganische Pigmente enthaltenden Schönungsmittel entwickelt und der Überschuß an Schönungsmittel entfernt wird, und

(B) die das gebildete Bild tragende Grundplatte zumindest nach Entstehen des endgültigen Farbbildes durch Erhitzen des Ganzen auf eine Temperatur, die höher ist als 400°C, gebrannt wird, dadurch gekennzeichnet, daß die besagten anorganischen Pigmente ein Gemisch von KAIHEKI und TANSUISHOKU für Zyanfärbung, OHSHOKU für Gelbfärbung, ein Gemisch von MARON und SHOENSHI für Magentafärbung und TSUYAGURO für Schwarzfärbung umfassen.

6. Ein Verfahren zur Herstellung einer permanenten Farbfotografie nach Anspruch 5, bei der das besagte Magentabild von dem besagten schwarzen Bild gebildet wird.

7. Ein Verfahren zur Herstellung einer permanenten Farbfotografie nach Anspruch 5 oder 6, bei dem das besagte Brennverfahren bei einer Erhitzungsgeschwindigkeit vcn weniger als 4°C/Minute von Raumtemperatur auf 200°C in einer oxidierenden Atmosphäre ausgeführt wird.

8. Ein Verfahren zur Herstellung einer permanenten Farbfotografie nach Anspruch 5, bei der die Entwicklung ausgeführt wird, nachdem die dem Bild gemäß bereits mit Licht bestrahlte Oberfläche der lichtempfindlichen Schicht einem Lösungsmitteldampf ausgesetzt wurde, um sie anschwellen zu lassen.

9. Ein Verfahren zur Herstellung einer permanenten Farbfotografie nach einem der Ansprüche 5 bis 8, bei dem die besagte lichtempfindliche Schicht hitzehärtbar ist und ihre Oberfläche durch Erhitzen auf eine Temperatur von weniger als 200°C gehärtet wird, bevor eine neue lichtempfindliche Schicht aufgetragen wird.

10. Ein Verfahren zur Herstellung einer permanenten Farbfotografie nach Anspruch 5, bei dem zwischen den einzelnen lichtempfindlichen Schichten eine Zwischenschicht vorgesehen wird, die durch den Auftrag der nächsten lichtempfindlichen Schicht nicht beeinflußt wird.

**Revendications**

1. Photographie en couleurs permanentes ayant une image en couleurs formée de pigments inorganiques sur un support, caractérisée par le fait que lesdits pigments inorganiques sont composés d'un mélange de KAIHEKI et TANSUISHOKU pour la coloration cyan, OSHOKU pour la coloration jaune, d'un mélange de MARON et de SHOENSHI pour la coloration magenta et de TSUYAGURO pour la coloration noire.

2. Photographie en couleurs permanentes selon la revendication 1, où le support se compose de matériau inorganique non métallique.

3. Photographie en couleurs permanentes selon la revendication 1, où le support contient de l'argent et/ou du cuivre.

4. Photographie en couleurs permanentes selon les revendications 2 et 3, où le support contient un matériau céramique, argent ou cuivre.

5. Méthode de production d'une photographie en couleurs permanentes, comportant (A) la formation d'une image de couleurs en répétant chacun des stades (a) à (c) suivants,

(a) application sur un support d'une couche photosensible,

(b) exposition de ladite couche photosensible à une image à travers un film lithographique directement filtré et à couleurs séparées, puis

(c) développement de ladite couche en utilisant un bain de virage contenant des pigments inorganiques et en éliminant les excédents de bain, et

(b) cuisson du support de l'image formée, au moins après la formation de l'image en couleurs définitive, en chauffant l'ensemble à une température dépassant 400°C, caractérisé par le fait que lesdits pigments inorganiques sont composés d'un mélange de KAIREKI et TANSUISHOKU pour la coloration cyan, OHSHOKU pour la coloration jaune, d'un mélange de MARON et de SHOENSHI pour la coloration magenta et de TSUYAGURO pour la coloration noire.

6. Méthode de production d'une photographie en couleurs permanentes selon la revendication 5, où ladite image en magenta est formée avant la formation de ladite image en noir.

7. Méthode de production d'une photographie en couleurs permanentes selon la revendication 5 ou 6, où ledit procédé de cuisson est exécuté dans une atmosphère oxydante, le taux de chauffage de la température ambiante à 200°C étant inférieur à 4°C/minute.

8. Méthode de production d'une photographie en couleurs permanentes selon la revendication 5, où le développement se fait après exposition à la vapeur de solvant afin de gonfler la surface de la couche photosensible irradiée par la lumière.

9. Méthode de production d'une photographie en couleurs permanentes selon l'une quelconque des revendications 5 à 8, où ladite couche photosensible est une matière thermodurcissable et sa surface est durcie en la chauffant à une température de moins de 200°C avant de l'enduire d'une nouvelle couche photosensible.

10. Méthode de production d'une photographie en couleurs permanentes selon la revendication 5, où une couche intermédiaire, sur laquelle la nouvelle couche photosensible est sans effet, est insérée entre toutes les couches photosensibles.